Europäisches Patentamt

European Patent Office

Office européen des brevets

(11) Publication number: **0 203 516 B1**

(12) **EUROPEAN PATENT SPECIFICATION**

(45) Date of publication of patent specification: **07.10.92**

(21) Application number: **86106914.4**

(22) Date of filing: **21.05.86**

(51) Int. Cl.⁵: **H01L 29/80,** H01L 29/36, H01L 29/10, H01L 29/20, H01L 21/265, H01L 21/74, //H01L27/10

(54) **Field effect transistor.**

(30) Priority: **22.05.85 JP 108121/85**
**17.03.86 JP 56810/86**
**17.03.86 JP 56811/86**

(43) Date of publication of application:
**03.12.86 Bulletin 86/49**

(45) Publication of the grant of the patent:
**07.10.92 Bulletin 92/41**

(84) Designated Contracting States:
**DE FR GB IT**

(56) References cited:
**EP-A- 0 181 091**

**PATENT ABSTRACTS OF JAPAN, vol. 7, no. 267 (E-213)[1412], 29th November 1983; & JP-A-58 148 465 (MITSUBISHI DENKI K.K.) 03-09-1983**

(73) Proprietor: **HITACHI, LTD.**
**6, Kanda Surugadai 4-chome**
**Chiyoda-ku, Tokyo 100(JP)**

(72) Inventor: **Umemoto, Yasunari**
**D107, Koyasu-cho, 2-32**
**Hachioji-shi Tokyo(JP)**
Inventor: **Kotera, Nobuo**
**301, Minami-cho, 2-18-3**
**Kokubunji-shi Tokyo(JP)**
Inventor: **Ueyanagi, Kiichi**
**3-16-4, Hikari-cho**
**Kokubunji-shi Tokyo(JP)**
Inventor: **Hashimoto, Norikazu**
**2-19-14, Nanyoudai**
**Hachioji-shi Tokyo(JP)**
Inventor: **Matsunaga, Nobutoshi**
**1-1-34, Ohkubo**
**Shinjuku-ku Tokyo(JP)**
Inventor: **Wada, Yasuo**
**6-14-5, Ohtsuka**
**Bunkyo-ku Tokyo(JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

IEEE ELECTRON DEVICE LETTERS, vol. EDL-3, no. 9, September 1982, pages 248-250, IEEE, New York, US; W.T. ANDERSON, JR. et al.: "Long-term transient radiation-resistant GaAs FET's"

ELECTRONICS LETTERS, vol. 20, no. 2, 19th January 1984, pages 98-100, London, GB; Y. UMEMOTO et al.: "GaAs MESFETS with a buried p-layer for large-scale integration"

PATENT ABSTRACTS OF JAPAN, vol. 8, no. 277 (E-285)[1714], 18th December 1984; & JP-A-59 147 464 (NIPPON DENKI K.K.) 23-08-1984

Inventor: **Shukuri, Shoji**
**809, Maehara-cho, 3-40-1**
**Koganei-shi Tokyo(JP)**

(74) Representative: **Strehl, Schübel-Hopf, Groening**
**Maximilianstrasse 54 Postfach 22 14 55**
**W-8000 München 22(DE)**

## Description

The present invention relates to a field effect transistor as recited in the preamble of claim 1. Such a field effect transistor is known from PATENT ABSTRACTS OF JAPAN, Vol. 7 No. 267 (E213)(1412).

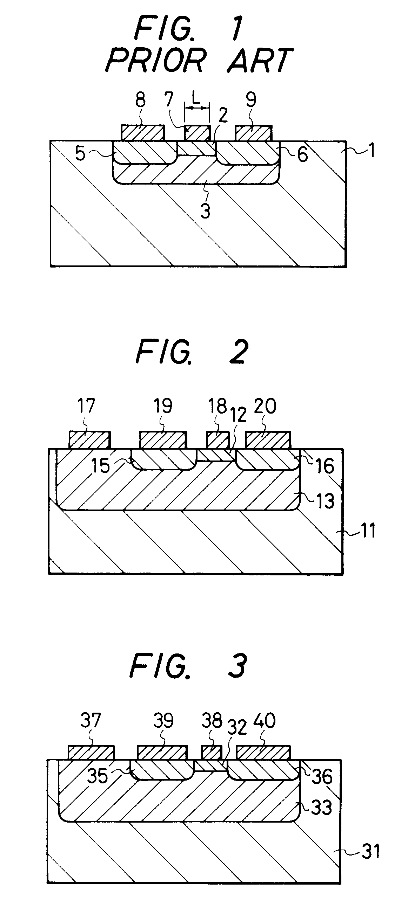

In GaAs MESFETs being one sort of a compound semiconductor field effect transistor, a structure as shown in Fig. 1 has been proposed in order to improve the performance (cf., for example, PATENT ABSTRACTS OF JAPAN; Vol.8 No. 277 (E285)(1714)).

The structure comprises a semi-insulating GaAs substrate 1, an active n layer 2, and a buried p layer 3 provided between the substrate 1 and the layer 2.

The main role of the buried p layer 3 is to suppress the short channel effect. The short channel effect is a phenomenon that, as the gate length L is decreased, the threshold voltage is significantly shifted to the negative direction. In other words, the short channel effect is a phenomenon produced in that electrons injected form a source $n^+$ layer 5 to the semi-insulating GaAs substrate 1 flow into a drain $n^+$ layer 6. Thus, in addition to a current path through the active n layer 2, there is another current path through the semi-insulating GaAs substrate 1. Consequently, the buried p layer 3 is provided so that the barrier at the side of the substrate is made high. In this constitution, injection of electrons to the substrate 1 is suppressed and the above-mentioned other current path is eliminated so as to suppress the short channel effect.

The buried p layer 3 in this structure is of low concentration and totally depleted, so that the parasitic capacitance between the active n layer 2 and the buried p layer 3 or between the $n^+$ layers 5, 6 and the buried p layer 3 is reduced and the element can act at high speed. Numeral 7 designates a gate electrode, numeral 8 a source electrode, and numeral 9 a drain electrode.

A similar device is known from ELECTRONIC LETTERS, Vol 20 No. 2, (1984), pages 98-100, which shows a buried p layer to control the active n layer thickness and thus to provide uniform threshold voltage.

However, the inventor has found that the GaAs MESFET with the above-mentioned structure is weak to $\alpha$-particles. That is, a memory such as a SRAM (Static Random Access Memory) constituted using this element is subjected to destruction of the stored information every time an $\alpha$-particle is entered. This phenomenon is called soft error.

Soft error in Si device was found by T.C May and M.H. Woods in 1979 (T.C May and M.H. Woods, IEEE Trans, Electron Device, ED-26, p2, 1979).

The generating mechanism of the soft error in the Si device is usually thought as follows. The stored information is held as a charge stored in a capacitor of a memory cell in the case of DRAM (Dynamic Random Access Memory) and as a height of potential at a node in the memory cell in the case of SRAM. When one $\alpha$-particle is entered in the Si substrate, pairs of electrons and positive holes of $10^6$ in number are generated along the $\alpha$-particle track in the Si substrate, and the carriers or electrons and positive holes are diffused or drifted in the substrate and flow in the capacitor or the node. Therefore the charge amount stored in the capacitor or the potential of the node varies significantly and the memory information held therein is destroyed. Also in the SRAM constituted using the GaAs MESFET having the buried p layer as shown in Fig. 1, the soft error seems to be generated in a similar mechanism.

Next, difference in the soft error phenomenon between the Si device and the GaAs MESFET having the structure of Fig. 1 will be described.

In the Si device, if the carriers generated along the track of one $\alpha$-particle are $10^6$ in the total number, the total amount of the charge flowing in the capacitor or the node is 160 fC at most (corresponding to flowing-in of all generated carriers) and not beyond 160 fC.

The inventor has repeated the measurements in the operation state of the GaAs MESFET having the structure of Fig. 1, and has found the difference between the GaAs MESFET and the Si device as follows.

In the GaAs MESFET having the structure of Fig. 1, the charge amount flowing in the capacitor or the node becomes several times larger than in the Si device when one $\alpha$-particle is entered.

This phenomenon means that the GaAs MESFET having the structure of Fig. 1 is liable to soft error by the $\alpha$-particles in comparison to the Si device.

This phenomenon means also that a carrier multiplication mechanism to multiply the charge flowing in the node exists in the GaAs MESFET having the structure of Fig. 1.

As one of the carrier multiplication mechanism, the inventor has found existence of the following mechanism. In this mechanism, the total amount of any of the positive charge (due to positive holes) and the negative charge (due to electrons) is of equal quality of 160 fC. Since the buried p layer 6 of the conventional structure is totally depleted, when a voltage is applied to the drain $n^+$ layer 6, the electric line of force extends from the drain $n^+$ layer 6 to the source $n^+$ layer 5, thereby drift of the generated carriers is promoted by the electric line of force. The mobility of electrons which determines the drift speed of carriers in GaAs is ten times or more than that of positive holes. Consequently, after the electrons are completely absorbed in the drain $n^+$ layer 6, positive holes still remain in the substrate. The potential barrier at the side of the substrate is lowered, and injection of electrons from the source $n^+$ layer 5 is promoted, thereby a subsidiary current path is formed and new current flows in the drain side. Thus a mechanism similar to the mechanism of short channel effect acts. Since the flowing-in charge becomes several times of 160 fC, carrier multiplication is observed.

In the above description, since the conduction type of the active layer 2, the source region 5 and the drain region 6 in Fig. 1 is of n type and the conduction type of the buried layer 3 is of p type, positive holes generated by $\alpha$-particles remain in the substrate and the carrier multiplication occurs. On the contrary, if the conduction type of the active layer 2, the source region 5 and the drain region 6 in Fig. 1 is made p type and the conduction type of the buried layer 3 is made n type, the multiplication effect of carriers does not occur, because the positive holes generated by the $\alpha$-particles remain in the substrate so as to suppress injection of positive holes from the source side. In this case, however, if one $\alpha$-particle enters the device, the total amount of charge flowing in the electrode becomes about 140 fC at maximum value and is still too large to avoid the soft error.

As described above, in the structure of providing the totally depleted buried layer under the active layer in order to prevent the short channel effect, soft errors due to $\alpha$-particles cannot be completely prevented.

According to the document mentioned at the beginning, from which the field effect transistor described in the preamble of claim 1 is known, the second semiconductor layer having a reverse conduction type is provided in order to shorten the lifetime of the pairs of electrons and positive holes generated by $\alpha$-rays, compared with the lifetime of the pairs in the GaAs substrate.

From IEEE ELECTRON DEVICE LETTERS, Vol. EDL-3 No. 9 (1982), pages 248-250 it is known that, in a depletion-mode GaAs FET, a p-type buffer layer below the active n layer shields this active layer from the effects of charges trapped in the substrate or at the buffer-substrate interface so that the depletion region at the bottom of the active layer is not sensitive to potential or charge variations in the underlying buffer layer or substrate material.

The object of the present invention is to provide a field effect transistor which can prevent the short channel effect and soft errors.

In accordance with the present invention, this object is achieved in a field effect transistor according to the preamble of claim 1 by the feature given in the characterizing part of the claim, that is by a control electrode which is electrically connected to said second semiconductor layer.

Preferred embodiments of the field effect transistor described in claim 1 are included in subclaims 2 and 3.

By way of example, the present invention is explained further with reference to the accompanying drawings, in which:

Fig. 1 is a sectional view of a field effect transistor in the prior art;

Fig. 2 is a sectional view of a field effect transistor illustrating the outlines of the invention;

Fig. 3 is a sectional view of a field effect transistor as a first embodiment;

Fig. 4 is a sectional view of a field effect transistor as a second embodiment;

Fig. 5 is a sectional view of a field effect transistor as a third embodiment;

Fig. 6 is a sectional view of a field effect transistor as a fourth embodiment;

Fig. 7 is a sectional view of a field effect transistor as a further example of a compound MESFET;

Fig. 8 is a sectional view of a field effect transistor as another example of a compound MESFET;

Fig. 9 is a sectional view of a field effect transistor as a fifth embodiment;

Fig. 10 is a sectional view of a field effect transistor as a sixth embodiment;

Fig. 11 is a sectional view of a field effect transistor as a further example of a compound MESFET;

Fig. 12 is a sectional view of a field effect transistor as a seventh embodiment;

Fig. 13 is a diagram illustrating the concept of a channeling implantation device; and

Fig. 14 is a sectional view of a field effect transistor as another example of a compound MESFET.

In a field effect transistor element, in order to suppress the carrier multiplication and prevent the soft error, for example, a buried p layer 13 being not totally depleted is formed under an active n layer 12 or under $n^+$ layers 15, 16 as shown in Fig. 2. Carrier concentration of the buried p layer 13 being not totally depleted is $10^{15}$ $cm^{-3}$ or more and preferably $10^{16}$ $cm^{-3}$ or more. If the carrier concentration is less than $10^{15}$ $cm^{-3}$, the layer is depleted and the carrier multiplication will occur. Therefore the carrier concentration is preferably $10^{15}$ $cm^{-3}$ at least. Further, if the carrier concentration is $10^{16}$ $cm^{-3}$ or more, it can be easily controlled. It is therefore preferable in practice that the carrier concentration becomes $10^{16}$ $cm^{-3}$ or more.

A control electrode 17 is installed to control the potential of the buried layer 13.

According to the FET with such structure, phenomenon of decrease of the potential barrier due to positive holes remaining solely in the substrate can be avoided, because the positive holes flow through the neutral region (region being not depleted) of the buried p layer 13 to the control electrode 17 and do not remain in the substrate.

Thus, injection of electrons from the source side into the substrate is suppressed, thereby the carrier multiplication is suppressed.

Also, when the conduction type of each layer is reversed to that of the above description, so that the conduction type of the source region 12, the active layer 15 and the drain region 16 is made p type and the conduction type of the buried layer 13 is made n type and further the control electrode 17 is installed, the soft error can be prevented. The electrons generated by the $\alpha$-particles flow then through the buried n layer 13 to the control electrode 17 and the positive holes are prevented from flowing into the layers 12, 15, 16 by the static potential of the buried n layer 13.

Summarizing this, when the active layer is n type and the buried layer is p type, the carrier multiplication is suppressed and further the total amount of flowing charge can be made less than the charge amount generated by the $\alpha$-particles. On the contrary, when the active layer is p type and the buried layer is n type, the total amount of flowing charge also can be made less than the charge amount generated by the $\alpha$-particles. Thus the element structure as shown in Fig. 2 can increase the immunity to $\alpha$-particle and prevent the soft error.

Embodiments of the invention will now be described.

First Embodiment:

Fig. 3 shows a field effect transistor similar to that of Fig. 2. A buried p layer 33, an active n layer 32 and n$^+$ layers 35, 36 are formed on a semi-insulating GaAs substrate 31 by means of ion implantation and subsequent high temperature annealing. The ion implantation of the buried p layer 33 may be performed using any of Be, Mg, C, Zn, and the implantation energy depends on the forming conditions of the active n layer 32 and the n$^+$ layers 35, 36, but is usually selected within the range of 70 keV ~ 300 keV. The dose depends on the implantation energy so as to satisfy the condition of being not totally depleated, but is usually selected within the range of 1 x 10$^{11}$ cm$^{-2}$ or more. The high temperature annealing is usually performed at a temperature of 700 °C ~ 850 °C. As a result, carrier concentration of the buried p layer

becomes 1 x 10$^{15}$ cm$^{-3}$ or more.

If the dose is 1 x 10$^{12}$ cm$^{-2}$ or more and the high temperature annealing is performed at 700 °C ~ 850 °C, the carrier concentration can be made 1 x 10$^{16}$ cm$^{-3}$ or more. The buried p layer is formed to a thickness of 100 nm or more. A source electrode 39, a drain electrode 40 and a gate electrode 38 are formed by a ordinary lift-off method. A control electrode 37 of the buried p layer 33 may be made of any metal making ohmic contact with the GaAs layer of p type, such as Cr or AuZn.

According to this embodiment, the carrier multiplication generated by $\alpha$-particles can be suppressed.

Second Embodiment:

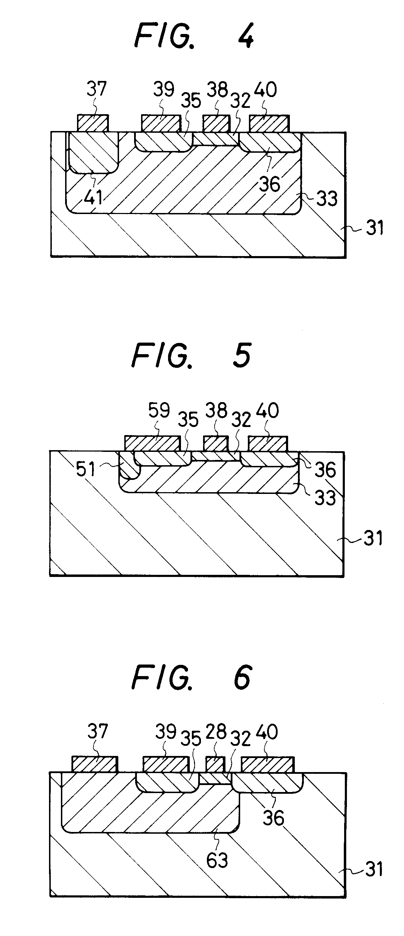

Fig. 4 shows a second embodiment. This embodiment is provided with p$^+$ layer 41 of higher concentration than that of the buried p layer 33 formed under the control electrode 37 in the FET with the structure shown in Fig. 3. The p$^+$ layer 41 is made by a high dose ion implantation of any of Mg, Be, C, Zn and a high temperature annealing process or a selective diffusion process of Zn using an insulation film as a mask. In the case of the ion implantation, the implantation energy is usually selected within the range of 10 keV ~ 300 keV and the dose is usually selected within the range of 10$^{13}$ cm$^{-2}$ or more. In the case of the selective diffusion of Zn, the diffusion is performed at a high temperature of 800 °C or more so that the surface concentration is made 10$^{18}$ cm$^{-3}$.

According to this embodiment, the contact resistance between the control electrode 37 and the buried p layer 33 can be decreased by one order of magnitude, and the carrier multiplication effect can be further reduced in comparison to the FET with the structure shown in Fig. 3. In the FET of Fig. 3, in order to provide an ohmic contact with the buried p layer 33, the control electrode 37 must be made of a metal such as Cr or AuZn being another metal than that used for the source electrode 39 or the drain electrode 40, i.e., a metal giving an ohmic resistance with a layer of n type, such as AuGe. In this embodiment, however, since the p$^+$ layer 41 is at high concentration, even if the control electrode 37 is made of a metal of the same sort as that of the source electrode 39 and the drain electrode 40, or of a metal of the same sort as that of the gate electrode 38, an ohmic contact can be realized. Consequently, addition of process steps for forming the control electrode 37 may be omitted and the whole manufacturing process can be simplified.

Third Embodiment:

Fig. 5 shows a third embodiment. In this embodiment, a $p^+$ layer 51 of high concentration is formed adjacent to the source $n^+$ layer 35, and a source electrode 59 is arranged on the $n^+$ layer 35 and on the $p^+$ layer 51 simultaneously.

According to this embodiment, the carrier multiplication can be suppressed in a similar manner as in the first and second embodiments, and further the device area can be decreased in comparison to these embodiments, thereby a high integration can be achieved.

In an integrated circuit, the carrier multiplication effect and the soft error during the $\alpha$-particle entering become a problem only at limited elements. If a buried layer is formed, the parasitic capacitance will increase. In order that such parasitic capacitance is not produced in the circuit and the circuit speed is maintained, the element structure as shown in Figs. 3 ~ 5 may be preferably adopted only at limited elements where the soft error becomes a problem. From this point of view, as shown in Figs. 3 ~ 5, an element in which the buried p layer 33 is selectively formed at a required portion is preferable to a structure where the buried layer is formed throughout the integrated circuit.

Fourth Embodiment:

Fig. 6 shows a fourth embodiment. In order to maintain the high speed of the integrated circuit as above described, the parasitic capacitance should be eliminated as much as possible. In this embodiment, in order to reduce the parasitic capacitance between the drain $n^+$ layer 36 and a buried p layer 63, the buried p layer 63 is not formed under the $n^+$ layer. In order to suppress the carrier multiplication effect and prevent the soft error during the $\alpha$-particle entering, the lowest condition is that the buried p layer 63 is formed entirely or partially under any one among the $n^+$ layer 35, the $n^+$ layer 36 and the active n layer 32. How the buried p layer 63 should be arranged depends on the design and the speed of the integrated circuit.

Further Example:

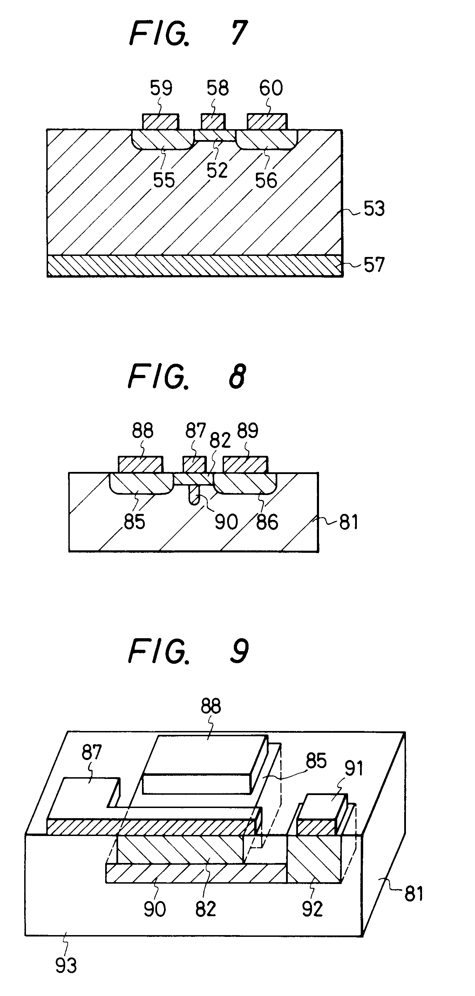

Fig. 7 shows a further example of a compound MESFET. An active n layer 52 and $n^+$ layers 55, 56 are formed on a p-type GaAs substrate 53 by ion implantation and a subsequent annealing process. The carrier concentration of the p-type substrate 53 is in the range of $10^{15}$ cm$^{-3}$ or more, so that the substrate is not totally depleted. A source electrode 59, a drain electrode 60 and a gate electrode 58 are formed by ordinary lift-off method. A control electrode 57 of the p-type substrate 53 may be made of any metal making an ohmic contact with p-type GaAs, such as Cr or AuZn or the like.

Another Example:

Fig. 8 shows a field effect transistor of a further example of a compound MESFET. A buried p layer 90, an active n layer 82 and $n^+$ layers 85, 86 are formed on a semi-insulating GaAs substrate 81 by ion implantation and a subsequent high temperature annealing process. The ion implantation of the buried p layer 90 may be performed using any of Be, Mg, C, Zn, and the implantation energy depends on the forming conditions of the n-type channel layer 82 and the $n^+$ layers 85, 86, but is usually selected within the range of 70 keV ~ 300 keV to aim a formation close to the channel layer 82. The dose depends on the implantation energy but is usually selected within the range of $1 \times 10^{11}$ cm$^{-2}$ or more so that the buried p layer 90 is not totally depleted. A focused ion beam is used in the ion implantation for forming the p-type layer 90. The beam diameter is about 0.2 $\mu m\phi$ and the finished width of the p-type layer 90 becomes about 0.25 $\mu m\phi$, whereby the capacitance increase due to the buried layer may be neglected. The high temperature annealing is usually performed at a temperature of 700 °C ~ 850 °C. A source electrode 88, a drain electrode 89 and a gate electrode 87 are formed by ordinary lift-off method.

According to such element structure, decrease of the potential barrier just under the channel layer 82 can be avoided even when positive holes remain in the substrate.

Fifth Embodiment;

Fig. 9 shows the structure of a fifth embodiment. In this embodiment, a buried p layer 90 is provided with a control electrode 91. Fig. 9 is a view along longitudinal direction of a gate electrode 87 and the buried layer 90 and from the side of a sectional surface 93 cutting nearly at the center between the gate electrode 87 and the buried layer 90. A drain electrode and a drain region exist approximately in symmetry of a source electrode 88 and a source region 85 with respect to the gate electrode 87 in a similar manner as in the above example. Forming conditions of source/drain region, source/drain electrode, the gate electrode 87, the channel 82 and the buried p layer 90 are also similar to that of the above example.

The $p^+$ layer 92 electrically connects the buried layer 90 and the control electrode 91, and may be formed by a high dose ion implantation of any of Mg, Be, C, Zn and the active annealing or by selective diffusion of Zn. Condition of the active annealing is a temperature of 700 ~ 850 °C for 15 minutes. The control electrode 91 may be made of Au/Mo, Au/Zn or Au/Cr, and gives an ohmic contact with the $p^+$ layer 92 by an alloy heat treatment (about 400 °C).

According to this embodiment, since positive holes generated by $\alpha$-particles under the channel layer 82 can be removed out of the FET through the burried layer 90, the carrier multiplication effect can be reduced.

Sixth Embodiment:

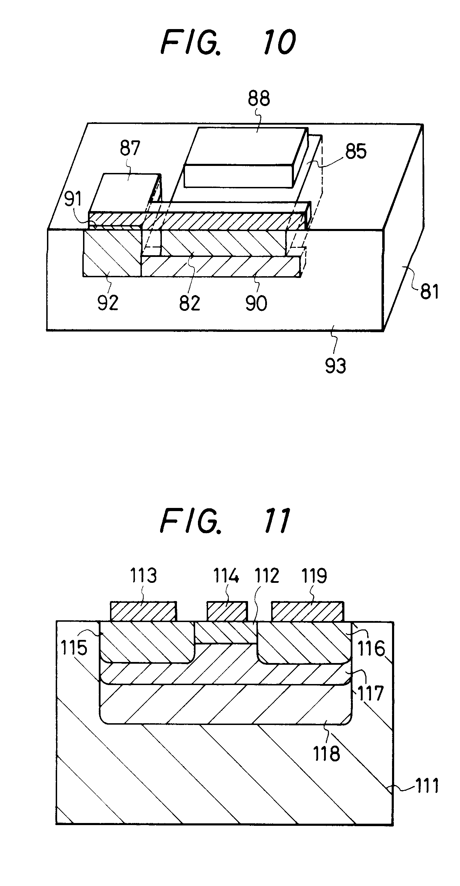

Fig. 10 shows an element structure of a sixth embodiment. In this embodiment, the gate electrode 87 and the control electrode 91 of the fifth embodiment are overlaid, thereby both are electrically connected. Fig. 10 is a view from a similar direction as in Fig. 9. This embodiment is similar to the fifth embodiment except for the forming position of the control electrode 91 and the $p^+$ layer 92. The $p^+$ layer 92 and the control electrode 91 are formed under the pad of the gate electrode 87. The forming method is similar to that of the fifth embodiment.

According to this embodiment, effects similar to that of the fifth embodiment are obtained, and not only the width of the depleted layer under the gate electrode but also the width of the depleted layer between the buried p layer 90 and the channel layer 82 can be simultaneously varied by the FET control voltage applied to the gate electrode 87, thereby the width of the channel layer can be controlled from upper and lower sides. The width of the buried p layer is less than the gate length, and therefore a transconductance being two times or more in comparison to the prior art can be obtained.

Further Example:

A further example of a compound MESFET will be described referring to Fig. 11. In order to only suppress the influence by $\alpha$-particle, the concentration in the buried p layer 3 in the structure of Fig. 1 may be made high so that the buried p layer 3 is not totally depleted. However, in this structure (high concentration of the buried p layer 3 in Fig. 1 so that the layer is not totally depleated), the parasitic capacitance of the element increases and the high speed of the element is inhibited. Consequently, in this example, a buried p layer 117 just under the active layer has a low concentration, and further a p-type layer 118 of high concentration is arranged at a deep portion. If the p-type layer 118 of high concentration is conductive, effects are obtained even when the p-type layer 117 of low concentration is not conductive (totally depleated). Generation of charge by $\alpha$-particles is a phenomenon occurring at a considerably deep portion in the substrate in comparison to the thickness of the active layer 112. We have confirmed that, when the p-type layer 118 of high concentration is arranged in such a deep portion, the effect of suppressing the influence of $\alpha$-particles scarcely varies. Further, according to this structure, increase of the parasitic capacitance due to the arrangement of the p-type layers 117, 118 can be made negligibly small.

Processes for achieving the structure of Fig. 11 will be described as follows. In this example, a semi-insulating GaAs substrate 111 is used, and all layers of n and p types are formed on the substrate 111 by ion implantation. First, ions to provide acceptor impurity, such as Be, Mg, Cd, C, are implanted to the semi-insulating GaAs substrate once or otherwise several times with an energy variation, thereby the p-type layers 117, 118 are formed. The ion implantation of high energy is required for the p-type layer of high concentration at a deep portion so as to decrease the capacitance, and is usually selected within the range of 150 keV ~ 3MeV. The dose depends on the implantation energy, but is usually selected within the range of $10^{11}$ cm$^{-2}$ or more. Next, ions to provide donor impurity, such as Si, Se, S, Te, are implanted so as to form the active n layer 112 and the $n^+$ layer 116. For the n layer 112, the energy and the dose are selected within the range of 30 ~ 100 keV and within the range of $10^{11}$ ~ $10^{13}$ cm$^{-2}$, respectively. For the $n^+$ layer 116, the energy and the dose are selected within the range of 30 ~ 200 keV and within the range of $10^{12}$ ~ $10^{15}$ cm$^{-2}$, respectively. The annealing after the ion implantation is performed at a temperature of 600 ~ 900 °C for 5 ~ 30 minutes. In usual, after all ion implantation is finished, annealing is performed once. However, the annealing of n type may be performed and then the p-type implantation annealing may be performed. Or, after the implantation annealing of the p-type layer and the active n layer, the gate 114 may be formed and a self-alignment implantation annealing of the $n^+$ layer may be performed. Of course, other various processes may be effected. Next, the ohmic electrode 113 and the gate electrode 114 are formed so as to constitute the FET.

Seventh Embodiment:

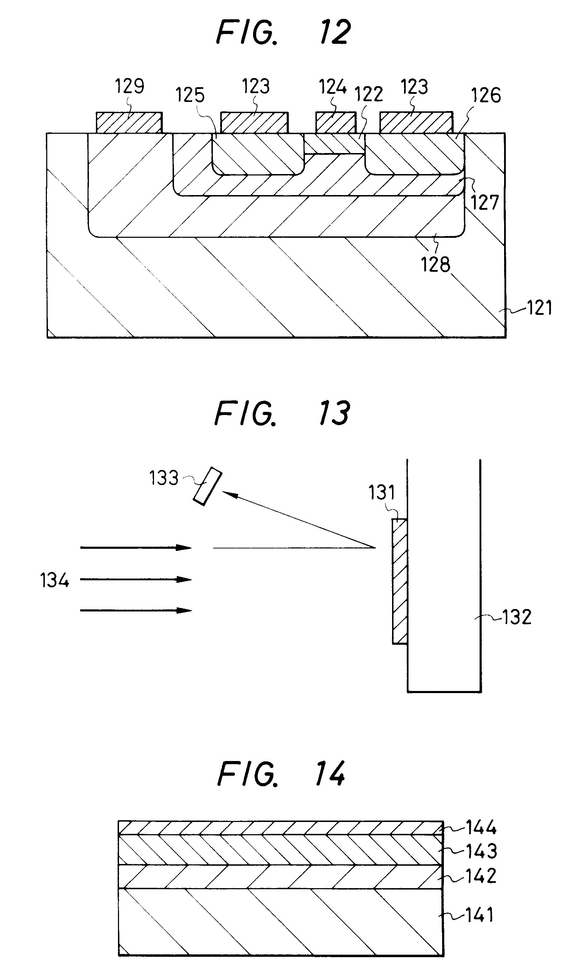

Fig. 11 shows a structure where the buried p layer 118 is not provided with an electrode. In a seventh embodiment as shown in Fig. 12, a control electrode 129 is added to the structure of Fig. 11, and the voltage of a buried p layer 128 can be controlled.

This embodiment also is formed by all ion implantation process in a similar manner as in the above example. However, in order to form the p-type layer 128 of high concentration at deep portion, the ion implantation of high energy is not used, but a ion implantation utilizing the channeling to obtain a deep p-type layer is performed.

Fig. 13 shows the concept of a channeling ion implantation device. First, a manipulator 132 is adjusted so that the ion beam 134 and the crystal axis (a low index axis such as ⟨100⟩, ⟨110⟩, ⟨111⟩) of the GaAs substrate 131 are arranged accurately in parallel to each other. The ion beam is produced by the ion implantation device and applied to the GaAs substrate 131. The reflected ions are received by a detector 133, and the incident angle to the GaAs crystal 131 is adjusted using the manipulator 132 so that the reflected ions become minimum. Next, when the same device is used, the ion beam is converted into ions to provide donor impurity to GaAs, such as Si, Se, S, and the ion implantation is again performed. Since the ion beam is entered in parallel to the crystal lattice of the GaAs crystal 131, the incident ions are not liable to scattering by the crystal lattice and can penetrate to deep portions in the crystal at low energy. Other n, $n^+$ layers and electrodes are formed in similar process to that described in the above example, thus completing the field effect transistor.

Another Example:

In another example of a compound MESFET, a transistor is produced using epitaxial growth or using epitaxial growth together with ion implantation. As shown in Fig. 14, on a semi-insulating GaAs substrate 141, epitaxial growth of a p-type GaAs layer 142 of high concentration, a p-type GaAs layer 143 of low concentration and an active n layer 144 is performed in this order. The epitaxial growth method may be any of metalorganic chemical vapor deposition (MO • CVD) method, molecular beam epitaxy (MBE) method, halogen vapor phase epitaxy (VPE) method and liquid phase epitaxy (LPE) method. The active layer (numeral 2 in Fig. 1) is epitaxially grown, and after the transistor is formed, mesa etching is performed or an ion implantation for elements to make GaAs high resistance, such as $O_2$, Cr, Fe, is performed, thereby an element separation is performed. Or, the epitaxial growth is performed only at the p-type layers 142, 143, and ions to provide donor impurity, such as Si, Se, S, may be selectively implanted in the p-type layer 143 of low concentration so as to form the active layer and the $n^+$ layers (numerals 2, 5, 6 in Fig. 1). Next, electrodes (numerals 8, 9 in Fig. 1) are formed in a similar process to that described in the above example, thus the field effect transistor being completed.

In the description of the above-mentioned embodiments, the conduction type of the buried layer or the substrate is made p type and the conduction type of the active layer is made n type. However, even when the conduction type is reversed, the amount of flowing-in of carriers during the α-particle entering can be made less than the charges generated by the α-particle.

Although the substrate material is limited to GaAs in the description, other compound semiconductor such as InP, GaAlAs, InGaAs, InGaAsP, of course, can suppress the carrier multiplication effect by the element structure of the present invention. The mobility of electrons in compound semiconductors is usually larger by one order of magnitude than the mobility of positive holes, thereby positive holes always remain in the substrate.

**Claims**

1. A field effect transistor comprising:

a first semiconductor layer formed in a surface region of a compound semiconductor substrate (31) and including a source region (35) and a drain region (36) having a first conduction type, and an active region (32) having said first conduction type and being formed between the source and drain regions (35, 36),

a gate electrode (38) formed on the active region (32),

a second semiconductor layer (33) of a second conduction type reverse to the first conduction type, being not totally depleted and formed under at least one of said source, drain and active regions (35, 36, 32),

characterized by

a control electrode (37) which is electrically connected to said second semiconductor layer (33).

2. A field effect transistor according to claim 1, characterized by a semiconductor layer (41) of said second conduction type having low resistance which is interposed between the second semiconductor layer (33) and said control electrode (37).

3. A field effect transistor according to claim 1, characterized in that said second semiconductor layer is composed of third and fourth semiconductor layers (117, 118), the third semiconductor layer (117) contacting said active region (112), and said fourth semiconductor layer (118) having a higher concentration than said third semiconductor layer (117).

**Patentansprüche**

1. Feldeffekttransistor mit

einer ersten Halbleiterschicht, die in einem Oberflächenbereich eines Verbindungshalbleiter-Substrates (31) ausgebildet ist und die einen Source-Bereich (35) und einen Drain-Bereich (36) eines ersten Leitungstyps sowie einen aktiven Bereich (32) des ersten Leitungstyps aufweist, der zwischen den Source- und Drain-Bereichen (35, 36) ausgebildet ist, mit

einer Gate-Elektrode (38), die auf dem aktiven Bereich (32) ausgebildet ist, und mit

einer zweiten Halbleiterschicht (33) eines zweiten Leitungstyps, der dem ersten Leitungstyp entgegengesetzt ist, die nicht vollständig verarmt ist und die unter wenigstens einem der Source-, Drain- und aktiven Bereiche (35, 36, 32) ausgebildet ist,

gekennzeichnet durch

eine Kontrollelektrode (37), die elektrisch mit der zweiten Halbleiterschicht (33) verbunden ist.

2. Feldeffekttransistor nach Anspruch 1, gekennzeichnet durch eine Halbleiterschicht (41) des zweiten Leitungstyps mit niedrigem Widerstand, die zwischen der zweiten Halbleiterschicht (33) und der Kontrollelektrode (37) angeordnet ist.

3. Feldeffekttransistor nach Anspruch 1, dadurch gekennzeichnet, daß die zweite Halbleiterschicht aus dritten und vierten Halbleiterschichten (117, 118) zusammengesetzt ist, wobei die dritte Halbleiterschicht (117) mit dem aktiven Bereich (112) in Kontakt steht und die vierte Halbleiterschicht (118) eine höhere Konzentration aufweist als die dritte Halbleiterschicht (117).

## Revendications

1. Transistor à effet de champ comprenant :

une première couche semiconductrice formée dans une région superficielle d'un substrat semiconducteur composite (31) et comprenant une région de source (35) et une région de drain (36) possédant un premier type de conduction, et une région active (32) possédant ledit premier type de conduction et formée entre les régions de source et de drain (35,36),

une électrode de grille (38) formée sur la région active (32),

une seconde couche semiconductrice (33) possédant un second type de conduction inverse du premier type de conduction, et qui n'est pas totalement appauvrie et est formée au-dessous d'au moins l'une de ladite région de source, de ladite région de drain et de ladite région active (35,36,32),

caractérisé par

une électrode de commande (37) qui est raccordée électriquement à ladite seconde couche semiconductrice (33).

2. Transistor à effet de champ selon la revendication 1, caractérisé par une couche semiconductrice (41) possédant ledit second type de conduction et une faible valeur résistive et qui est intercalée entre la seconde couche semiconductrice (33) et ladite électrode de commande (37).

3. Transistor à effet de champ selon la revendication 1, caractérisé en ce que ladite seconde couche semiconductrice est constituée par des troisième et quatrième couches semiconductrices (117,118), la troisième couche semiconductrice (117) étant en contact avec ladite région active (112) et ladite quatrième couche semiconductrice (118) possédant une concentration supérieure à celle de ladite troisième couche semiconductrice (117).

## FIG. 1
## PRIOR ART

## FIG. 2

## FIG. 3

FIG. 4

FIG. 5

FIG. 6

11

## FIG. 7

## FIG. 8

## FIG. 9

## FIG. 10

## FIG. 11

## FIG. 12

## FIG. 13

## FIG. 14